# EUROPÄISCHE PATENTSCHRIFT

(11) **EP 0 369 538 B1**
(45) Veröffentlichungstag und Bekanntmachung des Hinweises auf die Patenterteilung: **01.05.1996**
(21) Anmeldenummer: 89202866.3
(22) Anmeldetag: 13.11.1989
(51) Int. Cl.: G01R 33/54

(54) **Kernspintomographieverfahren zur Bestimmung der Kernmagnetisierung in einer Anzahl paralleler Schichten**
Nuclear spin tomography method for determining the nuclear magnetization in a number of parallel slices
Procédé de tomographie par spin nucléaire pour déterminer la magnétisation nucléaire dans un nombre de couches parallèles

(30) Priorität: 17.11.1988 DE 3838792
(43) Veröffentlichungstag der Anmeldung: 23.05.1990
(73) Patentinhaber: Philips Patentverwaltung GmbH, D-22335 Hamburg (DE); Philips Electronics N.V., NL-5621 BA Eindhoven (NL)
(72) Erfinder: Jensen, Jens Dye, Dr., D-2000 Hamburg 56 (DE)
(74) Vertreter: Hartmann, Heinrich, Dipl.-Ing.

(56) Entgegenhaltungen:
- EP-A- 0 132 975
- EP-A- 0 143 602
- EP-A- 0 213 858
- DE-A- 3 721 639
- US-A- 4 086 492
- US-A- 4 674 046
- SOCIETY OF MAGNETIC RESONANCE IN MEDICINE, 7TH ANNUAL MEETING AND EXHIBITION, San Francisco, 20. - 26. August 1988, Seite 117; D. JENSEN et al.: "SLIM - A novel approach to fast MR imaging"

## Beschreibung

Bei verschiedenen Kernspinuntersuchungen möchte sich der Arzt zunächst einen groben Überblick über die Kernmagnetisierungsverteilung in einem dreidimensionalen Volumenbereich verschaffen. Es sind zu diesem Zweck Verfahren bekannt, bei denen auf den Volumenbereich eine Vielzahl von Sequenzen einwirken, die mindestens einen Hochfrequenzimpuls umfassen, der auf den gesamten Volumenbereich einwirkt. Derartige Verfahren erfordern einen sehr hohen Dynamikbereich bei der Verarbeitung der im Volumenbereich erzeugten Kernresonanzsignale und dauern relativ lange, weil das im Anschluß an jeden Hochfrequenzimpuls ein- und ausgeschaltete magnetische Gradientenfeld von Sequenz zu Sequenz in zwei zueinander senkrechten Richtungen geändert werden muß.

Es ist ebenfalls bekannt, daß die Kernmagnetisierungsverteilung in einem dreidimensionalen Bereich durch Erfassung der Kernmagnetisierung in einer Anzahl aneinander angrenzender paralleler Schichten bestimmt werden kann. Die sogenannte Mehrfach-Schicht- (Multi-Slice) Verfahren - vgl. "Principles of MR Imaging", Hrsg. Philips Medical Systems 1984, S. 48 - führen dabei zu geringen Gesamtmeßzeiten. Bei diesen Verfahren wird die Repetitionszeit, die im Anschluß an eine Sequenz verstreichen muß, bevor die nächste Sequenz auf die gleiche Schicht einwirken kann, dazu benutzt, die Kernmagnetisierung in anderen Schichten anzuregen. Dabei ergibt sich eine Gesamtmeßzeit, die durch das Auflösungsvermögen und die Repetitionszeit bestimmt ist. Wenn die Kernmagnetisierungsverteilung in den einzelnen Schichten des Volumenbereichs mit einem Auflösungsvermögen von 128 x 128 Bildpunkten bestimmt werden soll und die Repetitionszeit 1 Sekunde beträgt, dann ergibt sich dabei immer noch eine Meßzeit von mehr als 2 Minuten.

Aufgabe der vorliegenden Erfindung ist es, ein Verfahren anzugeben, das es gestattet, die Meßzeit für die Aufnahme eines Satzes von zweidimensionalen Übersichtsbildern ("Scout Scan") der Kernmagnetisierungsverteilung zu reduzieren, ohne daß die Anforderungen an den Dynamikbereich bei der Verarbeitung der Kernresonanzsignale erhöht werden.

Diese Aufgabe wird erfindungsgemäß durch die im Hauptanspruch angegebenen Maßnahmen gelöst. Bei der Erfindung werden also nicht die Schichten angeregt, deren Kernmagnetisierungsverteilung in den Übersichtsbildern dargestellt werden soll, sondern dazu senkrechte, als Orthogonalschichten bezeichnete Schichten. Infolgedessen muß die Kernmagnetisierungsverteilung in der Schicht aus den Kernmagnetisierungsverteilungen der Orthogonalschichten ermittelt werden. Weil die Zahl der Schichten wesentlich kleiner sein kann als die Zahl der Bildpunkte in jeder der beiden parallel zur Schicht verlaufenden Richtungen, ist es möglich, die Orthogonalschichten nacheinander durch eine ununterbrochene Folgende von Sequenzen anzuregen, ohne daß der zeitliche Abstand zwischen zwei aufeinanderfolgenden Anregungen der gleichen Orthogonalschicht kleiner wird als die Repetitionszeit.

Es ist an sich aus der US-A-46 74 046 bekannt, daß man aus einem Satz paralleler - im Abstand voneinander befindlicher - Schichten nachträglich eine Schicht mit beliebiger Orientierung rekonstruieren kann, jedoch ist nicht erkennbar, daß dadurch die Meßzeit reduziert werden könnte.

Zur Durchführung des Verfahrens wird ausgegangen von einem Kernspintomographen mit einem Magneten zur Erzeugung eines homogenen stationären Magnetfeldes, einer Hochfrequenzspulenanordnung zur Erzeugung von magnetischen Hochfrequenzimpulsen, einer Gradientenspulenanordnung zum Ein- und Ausschalten eines magnetischen Gradientenfeldes während und nach dem Hochfrequenzimpuls, einer Rekonstruktionseinheit zur Rekonstruktion der Kernmagnetisierungsverteilung, einer Speicheranordnung zum Speichern der Kernmagnetisierungsverteilung sowie mit einer Steuereinheit zur Steuerung der verschiedenen Komponenten, wobei erfindungsgemäß vorgesehen ist, daß die Steuereinheit so ausgebildet ist, daß zur Ermittlung der Kernmagnetisierungsverteilung in einer Anzahl paralleler Schichten zunächst in einem ersten Meßzyklus fortlaufend eine Vielzahl dazu senkrechter, aneinander grenzender Orthogonalschichten, deren Zahl größer ist als die Zahl der Schichten, durch je eine Sequenz angeregt wird, die jeweils die Erzeugung mindestens eines schichtselektiven Hochfrequenzimpulses bei auf dem Untersuchungsbereich einwirkenden Schichtselektionsgradienten und nachfolgend das Ein- und Ausschalten eines zu den Schichten senkrechten magnetischen Phasenkodierungs-Gradientenfeldes sowie das Empfangen eines Kernresonanzsignals in Verbindung mit einem Lesegradienten umfaßt, daß in einem weiteren Zyklus diese Schichten erneut angeregt werden, wobei von Zyklus zu Zyklus das zeitliche Integral über das Phasenkodierungs-Gradientenfeld variiert wird, daß aus den Kernresonanzsignalen die Kernmagnetisierungsverteilung in den Orthogonalschichten bestimmt wird und daß aus den so berechneten Verteilungen die Kernmagnetisierungsverteilung in der Schicht ermittelt wird.

Die Erfindung wird nachstehend anhand der Zeichnung näher erläutert. Es zeigen:
- Fig. 1: einen Kernspintomographen, mit dem das erfindungsgemäße Verfahren ausführbar ist,
- Fig. 2: ein Blockschaltbild eines solchen Gerätes,
- Fig. 3: die räumliche Lage der Schichten und der Orthogonalschichten in bezug auf ein Untersuchungsobjekt,
- Fig. 4: den zeitlichen Verlauf der Signale bei einer Sequenz und
- Fig. 5: den zeitlichen Verlauf der Signale in einem Zyklus von Sequenzen.

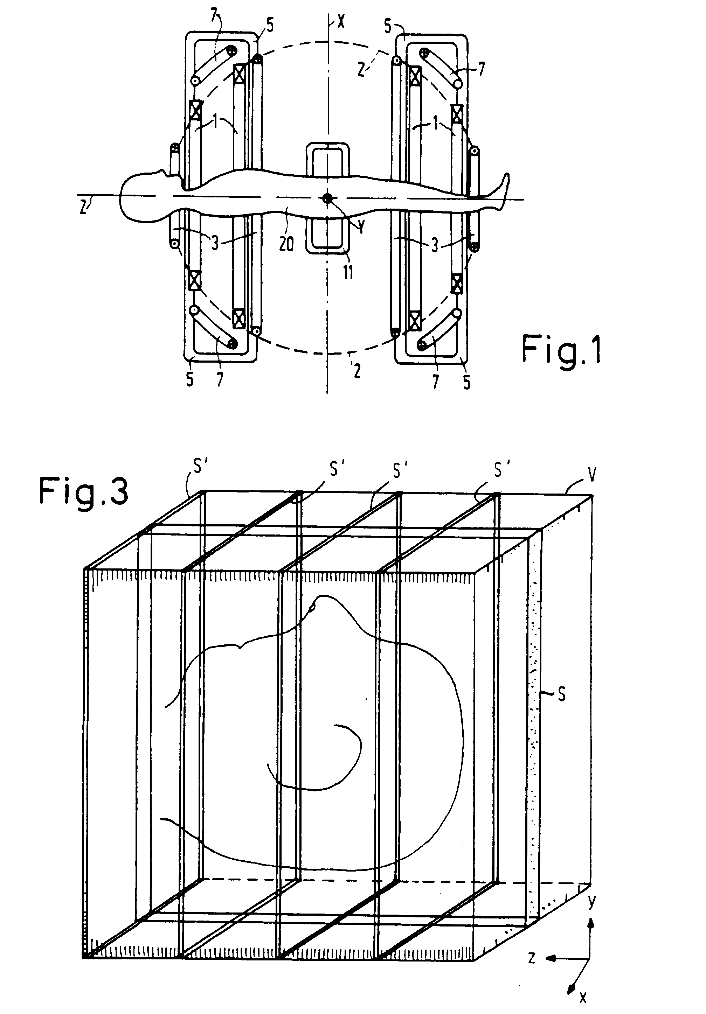

Der in Fig. 1 schematisch dargestellte Kernspintomograph enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen Spulen 5 sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen x,y,z-Koordinatensystems bildet, nur durch das stationäre homogene Magnetfeld der Spulenanordnung 1 bestimmt.

Weiterhin ist eine Hochfrequenzspule 11 symmetrisch zur Ebene z=0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld, erzeugt wird. Der Hochfrequenzspule wird während jedes Hochfrequenzimpulses ein hochfrequenter modulierter Strom von einem Hochfrequenzgenerator zugeführt. - Im Anschluß an einen oder mehrere Hochfrequenzimpulse dient die Hochfrequenzspule 11 zum Empfangen der durch Kernspinresonanz im Untersuchungsbereich erzeugten Echosignale. Stattdessen könnte aber auch eine gesonderte Hochfrequenzempfangsspule verwendet werden.

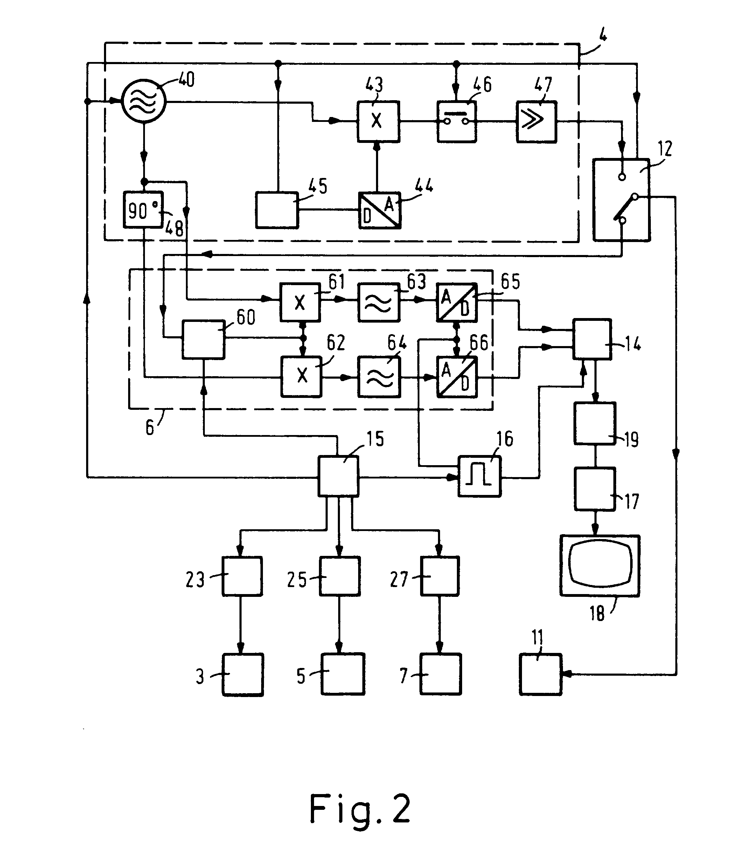

Fig. 2 zeigt ein vereinfachtes Blockschaltbild dieses Kernspintomographen. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz z.B. von Wasserstoffatomkernen erzeugt. Die Larmorfrequenz f berechnet sich bekanntlich nach der Beziehung f = cB, wobei B die magnetische Flußdichte in dem stationären homogenen Magnetfeld darstellt und c das gyromagnetische Verhältnis, das beispielsweise für Wasserstoffatomkerne 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Eingang mit einem digitalen Speicher 45 verbunden ist. Aus dem Speicher 45 wird - gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenzleistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten, durch Kernspinresonanz hervorgerufenen Echosignale zugeführt werden, wenn die Umschalteinrichtung 12 entsprechend gesteuert ist. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers 60 ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüber liegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Zwischenspeicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten Signale in eine Folge digitaler Datenworte umgesetzt und in dem Speicher 14 gespeichert werden können.

Die drei Gradientenspulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Zwischenspeicher 14 gespeicherten Datenworte bzw. Abtastwerte werden einer Rekonstruktionseinheit 19 zugeführt, die daraus die räumliche Verteilung der Kernmagnetisierung in den verschiedenen Orthogonalschichten ermittelt und die ermittelte Verteilung in einer Speicheranordnung 17 speichert. Die Kernmagnetisierungsverteilung kann an einem Monitor 18 dargestellt werden.

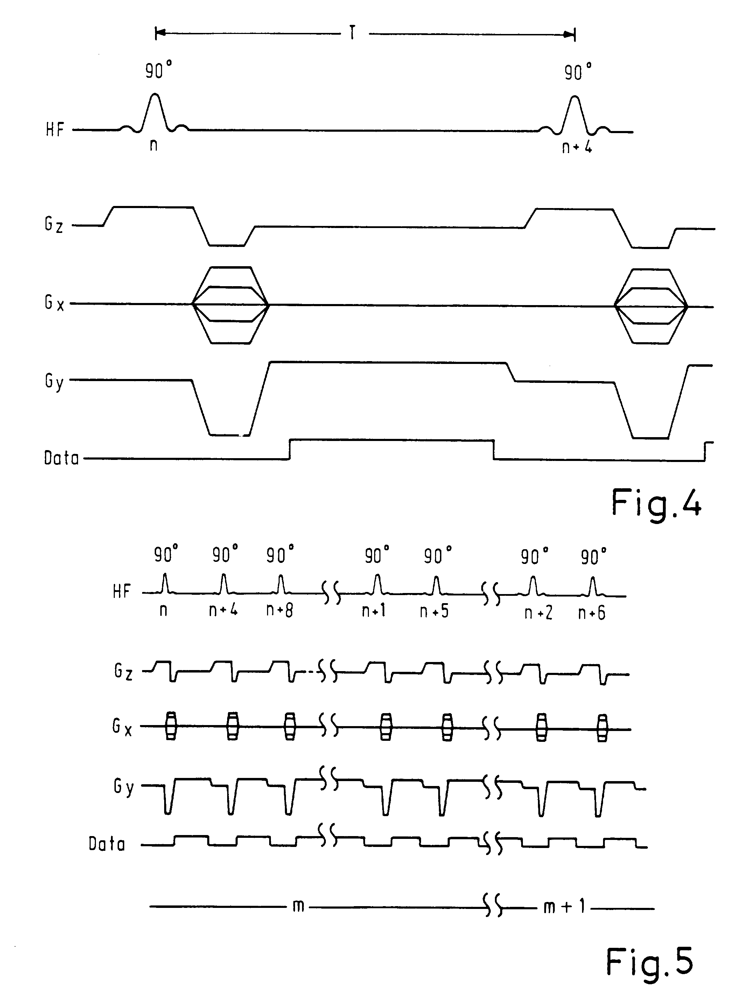

Fig. 3 zeigt als Beispiel die Aufnahme eines Satzes von einen Sagittalschnitt darstellenden Übersichtsbildern durch einen Schädel. Die Übersichtsbilder stellen die Kernmagnetisierungsverteilung in nₓ aneinander angrenzenden, relativ dicken Schichten dar, die zusammen einen etwa kubusförmigen Volumenbereich V definieren. Dabei kann z.B. nₓ = 32 sein. Die Schichten erstrecken sich parallel zur y-z-Ebene. Fig. 3 zeigt nur eine dieser Schichten S in ausgezogenen Linien.

Zur Bestimmung der Kernmagnetisierungsverteilung in der Schicht S (und in den dazu parallelen Schichten) wird die Kernmagnetisierung in dazu senkrecht verlaufenden, relativ dünnen und den aneinander grenzenden Schichten S′ angeregt, die zusammen den Volumenbereich V definieren. Diese Schichten S′, die parallel zur x-y-Ebene verlaufen und deren Zahl n_{z} ist, werden im folgenden "Orthogonalschichten" genannt. Mit den bei der Anregung der Orthogonalschichten gewonnenen Kernresonanzsignalen wird die Kernmagnetisierungsverteilung in den Orthogonalschichten bestimmt, woraus sich die Kernmagnetisierungsverteilung in den Streifen ableiten läßt, in denen die betreffende Schicht S von den einzelnen Orthogonalschichten geschnitten wird. Die Dicke der Orthogonalschichten bestimmt das Auflösungsvermögen in z-Richtung. Es sei angenommen, daß in dem Volumenbereich V n_{z} = 128 Orthogonalschichten S′ enthalten sind - also wesentlich mehr als Schichten S.

Auf jede der n_{z}-Orthogonalschichten S′ wirken dabei nₓ-Sequenzen ein, d.h. soviel, wie Schichten S in dem Volumenbereich V enthalten sind, im Beispiel also 32. Von Sequenz zu Sequenz wird dabei die Amplitude eines der Phasenkodierung dienenden Magnetfeldes geändert, dessen Gradient senkrecht zu der gewünschten Schicht S, d.h., in x-Richtung verläuft. Beim Auslesen der Kernresonanzsignale wird ein magnetisches Gradientenfeld mit einem in der verbleibenden Richtung, d.h. in y-Richtung verlaufenden Gradienten, angelegt und dieses Kernresonanzsignal wird dabei n_{y} mal abgetastet, wobei n_{y} vorzugsweise gleich n_{z} ist, im Beispiel also 128. Die auf diese Weise für die Abtastwerte der aus einer Orthogonalschicht resultierenden Kernresonanzsignale werden in der üblichen Weise in der Rekonstruktionseinheit 19 einer zweidimensionalen Fouriertransformation unterzogen, woraus sich die Kernmagnetisierungsverteilung in der betreffenden Orthogonalschicht ergibt. Anschließend wird die Kernmagnetisierungsverteilung in der Schicht S aus der Kernmagnetisierungsteilung in den Streifen zusammengesetzt, in denen die Orthogonalschichten S′ die betreffende Schicht S schneiden.

Fig. 4 zeigt den zeitlichen Verlauf der Signale in einer Sequenz. Jede Sequenz umfaßt einen in Anwesenheit eines magnetischen Gradientenfeldes G_{z} (2. Zeile) erzeugten Hochfrequenzimpuls (1. Zeile), der die Kernmagnetisierung in einer beliebigen Orthogonalschicht um 90° aus der z-Richtung kippt. Nach diesem Hochfrequenzimpuls wird zwecks Phasenkodierung das magnetische Gradientenfeld Gₓ ein- und ausgeschaltet (3. Zeile). Darüberhinaus wird dann das magnetische Gradientenfeld G_{y} zunächst mit negativer und nach dem Ausschalten des Gradientenfeldes Gₓ mit positiver Polarität (oder umgekehrt) eingeschaltet (4. Zeile). Wenn das zeitliche Integral über das Gradientenfeld G_{y} den Wert Null hat, ist die durch dieses Gradientenfeld beeinflußte Kernmagnetisierung refokussiert, und das um diesen Zeitpunkt herum, - d.h. nach Abschalten des Gradientenfeldes Gₓ und vor dem Abschalten des Gradientenfeldes G_{y} - auftretende Kernresonanzsignal wird erfaßt und im Empfänger 6 verarbeitet. In dem genannten Intervall wird der Taktimpulsgenerator 16 freigegeben (das Freigabesignal ist in der 5. Zeile dargestellt), so daß die von der Hochfrequenzspule 11 gelieferten, in den Niederfrequenzbereich transponierten Signale in eine Folge digitaler Datenworte umgesetzt und in dem Zwischenspeicher gespeichert werden. Der Zeitraum, während dessen der Taktimpulsgenerator 16 freigegeben ist, ist dabei n_{y} mal so groß wie die Periodendauer der vom Taktimpulsgenerator 16 erzeugten Taktimpulse, so daß jeweils 128 Wertepaare in den Zwischenspeicher 14 übernommen werden.

Nach dem Ende dieses Freigabezeitraumes und nach dem Abschalten des magnetischen Gradientenfeldes G_{y} ist die Sequenz für die n-te Orthogonalschicht beendet, (die Nummer -n- der Schicht ist jeweils unter dem Hochfrequenzimpuls angegeben), und es kann die nächste Sequenz erzeugt werden, allerdings für eine andere Orthogonalschicht. Vorzugsweise wird die Frequenz des Hochfrequenzimpulses (d.h. die Frequenz des Oszillators 40) dabei so gewählt, daß nicht die nächste Orthogonalschicht (n + 1) angeregt, sondern die vierte auf die Orthogonalschicht n folgende Orthogonalschicht (n + 4), so daß die Artefakte vermieden werden können, die bei der zeitliche aufeinanderfolgenden Anregung zweier unmittelbar benachbarter Schichten auftreten können. In dieser nachfolgenden Sequenz ist der zeitliche Verlauf der magnetischen Gradientenfelder Gₓ, G_{y} und G_{z} der gleiche wie in der vorangehenden Sequenz. Die Dauer T einer Sequenz kann beispielsweise 20 ms betragen.

Wie sich aus Fig. 5 ergibt, die die gleichen Signale wie Fig. 4, jedoch zeitlich komprimiert, zeigt, wird durch die übernächste Sequenz die Schicht n + 8 angeregt usw. Im weiteren Verlauf eines Zyklus werden dann die Schichten n + 1, n + 5 ..., später die Schichten n + 2, n + 6 ... und schließlich die Schichten n + 3, n + 7, ..., angeregt. Auf diese Weise werden im Verlauf eines Zyklus sämtliche Orthogonalschichten einmal angeregt.

Auf den zuvor erläuterten m-ten Zyklus folgt dann der Zyklus m + 1, in dessen Verlauf die Orthogonalschichten S′ durch je eine Sequenz in der gleichen Reihenfolge angeregt werden wie zuvor. Die Sequenzen unterscheiden sich von den Sequenzen des vorangegangenen Zyklus lediglich dadurch, daß der Phasenkodierungsgradient Gₓ dabei einen anderen Wert hat. Nach dem Zyklus m+1 folgen weitere Zyklen, wobei von Zyklus zu Zyklus lediglich der Phasenkodierungsgradient Gₓ geändert wird.

Nach nₓ(= 32) Zyklen sind die Messungen beendet. Die Meßzeit für einen Meßzyklus entspricht dem Produkt aus der Zahl n_{z} der Orthogonalschichten S′ und der Dauer T einer Sequenz; im angenommenen Beispiel ergibt sich daraus eine Meßzeit von rund 2,5 Sekunden pro Schicht. Diese Zeit, die zwischen zwei aufeinanderfolgenden Anregungen der gleichen Schicht verstreicht, ist so groß, daß die zuvor angeregte Kernmagnetisierung vollständig wieder abgeklungen ist. Die Gesamtmeßzeit ergibt sich aus der Zahl nₓ der Zyklen und der Dauer eines Zyklus. Bei den angegebenen Werten beträgt die Gesamtmeßzeit etwa 80 Sekunden.

Wären stattdessen die 32 Schichten S mit je einer Sequenz direkt angeregt worden, dann würde sich daraus als Dauer für einen Meßzyklus ein Wert von 640 ms (32 x T) ergeben. Nach dem Ende eines solchen Zyklus ist die Anregung der Kernmagnetisierung in der durch diesen Zyklus zuerst angeregten Schicht aber noch nicht abgeklungen, so daß noch eine Wartezeit verstreichen muß, bevor der nächste Zyklus beginnt. Auf diese Weise ergibt sich als zeitlicher Abstand zwischen zwei Zyklen ein Wert von mindestens 1000 ms. Wenn die Kernmagnetisierung in der Schicht mit einem Auflösungsvermögen von 128 x 128 Bildpunkten bestimmt werden soll, sind 128 derartige Zyklen erforderlich, was eine Meßzeit von mehr als zwei Minuten ergibt.

Bei dem erfindungsgemäßen Verfahren kann die Gesamtmeßzeit zudem dadurch noch weiter reduziert werden, daß die Anzahl der Orthogonalschichten S′ z.B. auf n_{z}′ reduziert und damit der Bildausschnitt auf den interessierenden Bereich beschränkt wird. Im Gegensatz zu den herkömmlichen zweidimensionalen Verfahren ist dies ohne Konsequenzen auf die räumliche Auflösung möglich, da die Bildrekonstruktion entlang der Richtung der Orthogonalschichten keine Fouriertransformation verlangt, sondern die gewünschten Bilder lediglich durch Aneinanderreihung der gemessenen Orthogonalschichten aufgebaut werden. Es können somit auch Bilder von n_{z}′ x 128 Bildpunkten zur Darstellung gebracht werden.

Aus den in den verschiedenen Zyklen gewonnenen Abtastwerten wird die Kernmagnetisierungsverteilung in den einzelnen Orthogonalschichten S′ in an sich bekannter Weise rekonstruiert. Pro Schicht ergeben sich dabei n_{y} x nₓ Bildpunkte, d.h. 128 x 32 Bildpunkte. Wenn man davon ausgeht, daß der Volumenbereich V etwa kubusförmig ist, bedeutet dies, daß das Auflösungsvermögen in y-Richtung wesentlich größer ist, als in x-Richtung, d.h. in Richtung senkrecht zur Schicht.

Der Speicher 17 muß eine Speicherkapazität haben, die zumindest ausreicht, die Kernmagnetisierung von nₓ x n_{y} x n_{z} (32 x 128 x 128) Bildpunkten zu speichern. Das Einschreiben der rekonstruierten Kernmagnetisierungsverteilung in den Speicher 17 kann dabei so erfolgen, daß die Kernmagnetisierung der Bildpunkte, die die gleichen x-Koordinate haben, unter aufeinanderfolgenden Adressen im Speicher gespeichert werden, so daß bei einem Auslesen des Speicherinhalts mit aufsteigender Adressenfolge die Kernmagnetisierungsverteilung Schicht für Schicht ausgelesen wird. Stattdessen ist es aber auch möglich, die Kernmagnetisierung jeder Orthogonalschicht in einem zusammenhängenden Adreßbereich zu speichern und beim Auslesen die Adressen so vorzugeben, daß die Kernmagnetisierungsverteilung jeweils einer Schicht ausgelesen wird. Die Ermittlung der Kernmagnetisierungsverteilung in den Schichten S aus der Kernmagnetisierungsverteilung der Orthogonalschichten S' läuft somit auf einen Sortiervorgang entweder beim Einschreiben in den Speicher 17 oder beim Auslesen aus dem Speicher hinaus.

Vorstehend wurde die Erfindung anhand eines Ausführungsbeispiels erläutert, bei dem jede Sequenz nur einen einzigen schichtselektiven Hochfrequenzimpuls umfaßt. Stattdessen können die Orthogonalschichten aber auch durch Sequenzen mit jeweils einem schichtselektiven 90°-Hochfrequenzimpuls angeregt werden, dem ein schichtselektiver 180°-Hochfrequenzimpuls folgt, wobei das resultierende Spin-Echo-Signal zur Rekonstruktion der Kernmagnetisierungsverteilung herangezogen wird. Bei diesen Sequenzen kann der Bildkontrast u.a. durch die Wahl des zeitlichen Abstandes zwischen den beiden Hochfrequenzimpulsen, der sogenannten Echozeit, beeinflußt werden. Um bei größeren Echozeiten die Gesamtmeßzeit nicht wesentlich zu verlängern, kann es dabei zweckmäßig sein, die einzelnen Sequenzen zeitlich ineinander zu verschachteln, wie in der DE-OS 36 31 039 beschrieben. Dabei wird der erste Hochfrequenzimpuls einer Sequenz erzeugt, bevor das Spin-Echo-Signal aus der vorangehenden Sequenz empfangen worden ist.

## Patentansprüche

1. Kernspintomographieverfahren, bei dem zur Ermittlung der Kernmagnetisierungsverteilung in einer Anzahl paralleler Schichten (S) zunächst in einem ersten Meßzyklus fortlaufend eine Vielzahl dazu senkrechter, aneinander grenzender Orthogonalschichten (S'), deren Zahl (n_{z}) größer ist als die Zahl (nₓ) der Schichten (S), durch je eine Sequenz angeregt wird, die jeweils die Erzeugung mindestens eines schichtselektiven Hochfrequenzimpulses bei einem auf den Untersuchungsbereich einwirkenden Schichtselektionsgradienten (Gz) und nachfolgend das Ein- und Ausschalten eines zu den Schichten (S) senkrechten magnetischen Phasenkodierungs-Gradientenfeldes (Gx) sowie das Empfangen eines Kernresonanzsignals in Verbindung mit einem Lesegradienten (Gy) umfaßt, daß in weiteren Zyklen diese Schichten erneut angeregt werden, wobei von Zyklus zu Zyklus das zeitliche Integral über das Phasenkodierungs-Gradientenfeld (Gx) variiert wird, daß aus den Kernresonanzsignalen die Kernmagnetisierungsverteilung in den Orthogonalschichten (S') bestimmt wird und daß aus den so berechneten Verteilungen die Kernmagnetisierungsverteilung in den Schichten (S) ermittelt wird.

2. Kernspintomographieverfahren nach Anspruch 1,
wobei innerhalb eines Zyklus im Abstand voneinander befindliche Schichten durch aufeinanderfolgende Sequenzen angeregt werden.

3. Kernspintomographieverfahren nach Anspruch 1,
wobei jede Sequenz jeweils eine Schicht durch einen 90°-Hochfrequenzimpuls und einen nachfolgenden 180°-Hochfrequenzimpuls anregt, wobei die dabei erzeugten Spin-Echo-Signale zur Rekonstruktion der Kernmagnetisierungsverteilung herangezogen werden, und daß die Sequenzen eines Zyklus zeitlich ineinander verschachtelt sind, derart, daß der erste Hochfrequenzimpuls einer Sequenz erzeugt wird, bevor das durch die vorangehende Sequenz erzeugte Spin-Echo-Signal empfangen worden ist.

4. Kernspintomograph zur Durchführung des Verfahrens nach Anspruch 1 mit einem Magneten (1) zur Erzeugung eines homogenen stationären Magnetfeldes, einer Hochfrequenzspulenanordnung (11) zur Erzeugung von magnetischen Hochfrequenzimpulsen, einer Gradientenspulenanordnung (3,5,7) zum Ein- und Ausschalten eines magnetischen Gradientenfeldes während und nach dem Hochfrequenzimpuls, einer Rekonstruktionseinheit (19) zur Rekonstruktion der Kernmagnetisierungsverteilung, einer Speicheranordnung (17) zum Speichern der Kernmagnetisierungsverteilung sowie mit einer Steuereinheit (15) zur Steuerung der verschiedenen Komponenten,
dadurch gekennzeichnet, daß die Steuereinheit (15) so ausgebildet ist, daß zur Ermittlung der Kernmagnetisierungsverteilung in einer Anzahl paralleler Schichten (S) zunächst in einem ersten Meßzyklus fortlaufend eine Vielzahl dazu senkrechter, aneinander grenzender Orthogonalschichten (S'), deren Zahl (n_{z}) größer ist als die Zahl (nₓ) der Schichten (S), durch je eine Sequenz angeregt wird, die jeweils die Erzeugung mindestens eines schichtselektiven Hochfrequenzimpulses bei auf dem Untersuchungsbereich einwirkenden Schichtselektionsgradienten (Gz) und nachfolgend das Ein- und Ausschalten eines zu den Schichten (S) senkrechten magnetischen Phasenkodierungs-Gradientenfeldes (Gx) sowie das Empfangen eines Kernresonanzsignals in Verbindung mit einem Lesegradienten (Gy) umfaßt, daß in einem weiteren Zyklus diese Schichten erneut angeregt werden, wobei von Zyklus zu Zyklus das zeitliche Integral über das Phasenkodierungs-Gradientenfeld (Gx) variiert wird, daß aus den Kernresonanzsignalen die Kernmagnetisierungsverteilung in den Orthogonalschichten (S') bestimmt wird und daß aus den so berechneten Verteilungen die Kernmagnetisierungsverteilung in der Schicht (S) ermittelt wird.

## Claims

1. A magnetic resonance tomography method, in which for the determination of the nuclear magnetization distribution in a number of parallel slices (S) first a plurality of adjacent orthogonal slices (S'), which extend perpendicularly thereto and whose number (n_{z}) is larger than the number (nₓ) of the slices (S), are continuously excited by a respective sequence during a first measuring cycle, each sequence including the formation of at least one slice-selective RF pulse in the presence of a slice selection gradient (Gz) acting on the examination zone and subsequently the switching on and off of a magnetic phase-encoding gradient field (Gx) extending perpendicularly to said slices (S), and also including the reception of a spin resonance signal in conjunction with a read gradient (Gy), said slices being excited again during further cycles, the time integral over the phase-encoding gradient field (Gx) being varied from one cycle to another, the nuclear magnetization distribution in the orthogonal slices (S') being determined from the spin resonance signals and the nuclear magnetization distribution in the slices (S) being determined from the distribution thus calculated.

2. A magnetic resonance tomography method as claimed in Claim 1, in which within a cycle slices which are situated at a distance from one another are excited by successive sequences.

3. A magnetic resonance tomography method as claimed in Claim 1, in which each sequence excites a respective slice by means of a 90° RF pulse and a subsequent 180° RF pulse, the spin echo signals thus generated being used for reconstructing the nuclear magnetization distribution, and the sequences of a cycle being interleaved in time in such a manner that the first RF pulse of a sequence is generated before the spin echo signal produced by the preceding sequence has been received.

4. A magnetic resonance tomography apparatus for performing the method claimed in Claim 1, comprising a magnet (1) for generating a uniform, steady magnetic field, an RF coil system (11) for generating magnetic RF pulses, a gradient coil system (3, 5, 7) for switching a magnetic gradient field on and off during and after the RF pulse, a reconstruction unit (19) for reconstructing the nuclear magnetization distribution, a storage device (17) for storing the nuclear magnetization distribution, and a control unit (15) for controlling the various components, characterized in that the control unit (15) is constructed so that for the determination of the nuclear magnetization distribution in a number of parallel slices (S) first a plurality of adjacent orthogonal slices (S'), which extend perpendicularly thereto and whose number (n_{z}) is larger than the number (nₓ) of the slices (S), are continuously excited by a respective sequence during a first measuring cycle, each sequence including the formation of at least one slice-selective RF pulse in the presence of a slice-selection gradient (Gz) acting on the examination zone and subsequently the switching on and off of a magnetic phase-encoding gradient field (Gx) extending perpendicularly to the slices (S), and also including the reception of a spin resonance signal in conjunction with a read gradient (Gy), said slices being excited again during a further cycle, the time integral over the phase-encoding gradient field (Gx) being varied from one cycle to another, the nuclear magnetization distribution in the orthogonal slices (S') being determined from the spin resonance signals and the nuclear magnetization distribution in the slice (S) being determined from the distribution thus calculated.

## Revendications

1. Procédé de tomographie par spin nucléaire dans lequel, pour la détermination de la distribution de la magnétisation nucléaire dans plusieurs couches parallèles (S), il faut d'abord, dans un premier cycle de mesure, exciter en continu plusieurs couches orthogonales (S') adjacentes et perpendiculaires à celles-ci dont le nombre (n_{z}) est supérieur au nombre (nₓ) des couches (S) par une séquence qui comprend respectivement la production d'au moins une impulsion à haute fréquence sélective de la couche pour les gradients de sélection de couches (G_{z}) agissant sur la région à examiner et ensuite l'activation et la désactivation d'un champ magnétique à gradient de codage de phase (Gₓ) perpendiculaire aux couches (S), ainsi que la réception d'un signal de résonance nucléaire associé à un gradient de lecture (G_{y}), caractérisé en ce que, dans des cycles ultérieurs, ces couches sont à nouveau excitées, l'intégrale temporelle variant par l'intermédiaire du champ à gradient de codage de phase (Gₓ) d'un cycle à l'autre, en ce que la distribution de la magnétisation nucléaire dans les couches orthogonales (S') est déterminée à partir des signaux de résonance nucléaire et en ce que la distribution de la magnétisation nucléaire est déterminée dans les couches (S) à partir des distributions ainsi calculées.

2. Procédé de tomographie par spin nucléaire selon la revendication 1, où des couches espacées l'une de l'autre dans un cycle sont excitées par des séquences successives.

3. Procédé de tomographie par spin nucléaire selon la revendication 1, où chaque séquence excite respectivement une couche par une impulsion à haute fréquence à 90° et une impulsion à haute fréquence à 180°C consécutive, où les signaux d'écho de spin ainsi produits sont utilisés pour la reconstruction de la distribution de la magnétisation nucléaire, et les séquences d'un cycle sont imbriquées dans le temps, de telle sorte que la première impulsion à haute fréquence d'une séquence soit produite avant que le signal d'écho de spin produit par la séquence précédente ne soit reçu.

4. Tomographe par spin nucléaire pour la réalisation du procédé selon la revendication 1 avec un aimant (1) pour la production d'un champ magnétique stationnaire homogène, un dispositif à bobines à haute fréquence (11) pour la production d'impulsions magnétiques à haute fréquence, un dispositif à bobines à gradient (3, 5, 7) pour l'activation et la désactivation d'un champ magnétique à gradient pendant et après l'impulsion à haute fréquence, une unité de reconstruction (19) pour la reconstruction de la distribution de la magnétisation nucléaire, un dispositif de mémoire (17) pour la sauvegarde de la distribution de la magnétisation nucléaire, ainsi qu'une unité de commande (15) pour la commande des différents composants,
caractérisé en ce que l'unité de commande (15) est conçue de telle sorte que, pour la détermination de la distribution de la magnétisation nucléaire dans plusieurs couches parallèles (S), il faut d'abord, dans un premier cycle de mesure, exciter en continu plusieurs couches orthogonales (S') adjacentes et perpendiculaires à celles-ci dont le nombre (n_{z}) est supérieur au nombre (nₓ) des couches (S) par une séquence qui comprend, respectivement, la production d'au moins une impulsion à haute fréquence sélective de la couche pour les gradients de sélection de couches (G_{z}) agissant sur la région à examiner et ensuite l'activation et la désactivation d'un champ magnétique à gradient de codage de phase (G_{z}) perpendiculaire aux couches (S), ainsi que la réception d'un signal de résonance nucléaire associé à un gradient de lecture (G_{y}), caractérisé en ce que, dans des cycles ultérieurs, ces couches sont à nouveau excitées, l'intégrale temporelle variant, par l'intermédiaire du champ à gradient de codage de phase (Gₓ), d'un cycle à l'autre, en ce que la distribution de la magnétisation nucléaire dans les couches orthogonales (S') est déterminée à partir des signaux de résonance nucléaire et en ce que la distribution de la magnétisation nucléaire est déterminée dans les couches (S) à partir des distributions ainsi calculées.
